# EUROPEAN PATENT APPLICATION

(11) **EP 4 826 634 A1**
(43) Date of publication of application: **21.10.2026**
(21) Application number: 24931890.8
(22) Date of filing: 18.07.2024
(51) Int. Cl.: G06Q 50/06, G01R 21/06, G06F 3/048, H02J 3/38

(54) **METHOD AND DEVICE FOR PROVIDING ENERGY CONSUMPTION SCORE OF CONSUMER**

(30) Priority: 25.03.2024 KR 20240040641
(71) Applicant: Hanwha Solutions Corporation, Jung-gu Seoul 04541 (KR)
(72) Inventor: KIM, Sang Min, Seoul 04541 (KR); CHO, Hyup, Seoul 04541 (KR)
(74) Representative: Mooser, Sebastian Thomas
(86) International application number: PCT/KR2024/010395
(87) International publication number: WO 2025/206476

(57) **Abstract**

Provided are a method and apparatus for providing an energy consumption score of a consumer, wherein the method includes: obtaining an amount of electrical energy consumption of a consumer according to a time period; obtaining an amount of grid electrical energy imported from a power grid in the amount of electrical energy consumption of the consumer; calculating an energy consumption score of the consumer based on the amount of electrical energy consumption and the amount of grid electrical energy; and generating an interface configured to display the energy consumption score.

## Description

### Technical Field

The present disclosure relates to a method and apparatus for providing an energy consumption score of a consumer and, more particularly, to a method and apparatus for calculating an energy consumption score of a consumer and generating an interface for displaying the energy consumption score.

### Background Art

Photovoltaics is a power generation technology able to generate power with almost no pollution by a process of directly collecting energy from the sun and converting the collected energy into electricity. As such, photovoltaics is a fast-growing sustainable energy source that is increasingly recognized as a green power source.

On the other hand, most electrical energy generation releases greenhouse gases and other air pollutants from burning fossil fuels, which are major contributors to climate change and air pollution. Therefore, a consumption culture that includes efficient use of electricity and the consumption of electrical energy produced by self-generation, such as solar power generation, may provide many environmental, economic, and social benefits.

The above background technology is technical information that the inventor(s) possessed for conceiving the present disclosure or acquired in the process of conceiving the present disclosure, and should not be considered prior art already known to the public prior to the filing of the present disclosure.

### Disclosure

### Technical Problem

The present disclosure is directed to provide a method and apparatus for providing an energy consumption score of a consumer. The objective of the present disclosure is not limited to the aforementioned description, and other objectives not explicitly disclosed herein will be clearly understood by a person having ordinary skill in the art from the description of the present disclosure, and will be understood more clearly according to embodiments of the present disclosure. It will also be appreciated that the above and other objectives and advantages of the present disclosure may be realized by means disclosed in the claims and combinations thereof.

### Technical Solution

In order to realize the above-described objective, a first aspect of the present disclosure provides a method of providing an energy consumption score of a consumer, the method including: obtaining an amount of electrical energy consumption of a consumer according to a time period; obtaining an amount of grid electrical energy imported from a power grid in the amount of electrical energy consumption of the consumer; calculating an energy consumption score of the consumer based on the amount of electrical energy consumption and the amount of grid electrical energy; and generating an interface configured to display the energy consumption score.

A second aspect of the present disclosure provides an apparatus for providing an energy consumption score of a consumer, the apparatus including: a memory having at least one program stored therein; and a processor configured to perform calculation by executing the at least one program, wherein the processor: obtains an amount of electrical energy consumption of a consumer according to a time period; obtains an amount of grid electrical energy imported from a power grid in the amount of electrical energy consumption of the consumer; calculates an energy consumption score of the consumer based on the amount of electrical energy consumption and the amount of grid electrical energy; and generates an interface configured to display the energy consumption score.

A third aspect of the present disclosure may provide a computer-readable recording medium having recorded thereon a program to cause the method of the first aspect to be executed on a computer.

In addition, other methods and other devices for implementing the present disclosure and other computer-readable recording media having recorded thereon a program for causing the methods to be executed on a computer may be provided.

Other aspects, features, and advantages in addition to those described above will become apparent from the following drawings, the claims, and the detailed description of the present disclosure.

### Advantageous Effects

According to the technical solution of the present disclosure described above, the status of electrical energy consumption may be provided, thereby leading to a motivation to improve electrical energy consumption and an incentive to use renewable energy.

In addition, according to the technical solution of the present disclosure, the status of electrical energy consumption may be provided to a user using a highly visible interface, thereby enhancing the user experience.

The effects of embodiments are not limited to the effects mentioned above, and other effects not mentioned will be clearly understood by a person having ordinary skill in the art from the description of the present disclosure.

### Description of Drawings

FIG. 1 is a view illustrating electrical energy flow of an electricity consumer according to an embodiment of the present disclosure.
FIG. 2 is an example view of an environment providing an energy consumption score of a consumer according to an embodiment of the present disclosure.
FIG. 3 is a view illustrating amounts of electrical energy consumed according to the time period according to an embodiment of the present disclosure.
FIG. 4 is an example view of an interface displaying an energy consumption score according to an embodiment of the present disclosure.
FIG. 5 is an example view of a virtual power plant (VPP) implementation according to an embodiment of the present disclosure.
FIG. 6 is a flowchart of a method of providing an energy consumption score of a consumer according to an embodiment of the present disclosure.
FIG. 7 is a block diagram of an apparatus for providing an energy consumption score of a consumer according to an embodiment of the present disclosure.

### Best Mode

A method of providing an energy consumption score of a consumer may be provided, including: obtaining an amount of electrical energy consumption of a consumer according to a time period; obtaining an amount of grid electrical energy imported from a power grid in the amount of electrical energy consumption of the consumer; calculating an energy consumption score of the consumer based on the amount of electrical energy consumption and the amount of grid electrical energy; and generating an interface configured to display the energy consumption score.

### Mode for Invention

In describing the present disclosure, a detailed description of related known configurations may be omitted to avoid obscuring the subject matter of the present disclosure, and all terms used herein have the same meaning as commonly understood by a person having ordinary skill in the art to which the present disclosure pertains unless explicitly stated otherwise.

Phrases such as "according to an embodiment," "relating to an embodiment," or "according to an implementation of an embodiment" in this specification do not necessarily refer to the same embodiment.

Embodiments may be variously modified in many different forms, and some embodiments will be illustrated and described in detail with reference to the accompanying drawings. However, this is not intended to limit the embodiments to specific disclosed forms, but the present disclosure should be understood to include all modifications, equivalents, and alternatives within the spirit and scope of the present disclosure. The terms used in the specification are merely used to describe the embodiments and are not intended to limit the embodiments.

The terms used in embodiments are chosen to be general terms that are currently used as broadly as possible while taking into account the functions in the embodiments, but this may vary depending on the intent of a person having ordinary skill in the art to which the embodiments pertain, the precedent, the emergence of new technologies, or the like. In addition, some terms are arbitrarily designated by the applicant for specific cases, and in such cases, the meaning of the terms will be described in detail in the relevant section. Therefore, the terms used in the embodiments should be defined based on the meaning of the terms and the overall content of the embodiments, rather than simply the names of the terms.

Some embodiments of the present disclosure may be represented by function block configurations and various processing steps. Some or all of these function blocks may be implemented using various numbers of hardware and/or software configurations executing specific functions. For example, the function blocks of the present disclosure may be implemented using one or more microprocessors, or may be implemented using circuit configurations for specific functions.

In addition, for example, function blocks of the present disclosure may be implemented using various programming or scripting languages. Function blocks may be implemented using algorithms that run on one or more processors. In addition, the present disclosure may employ related-art technologies for electronic environment setup, signal processing, and/or data processing.

Terms such as "database (DB)," "element," "means," and "configuration" may be used broadly and are not limited to mechanical or physical components. In addition, it will be understood that each term such as "section (or part)" or "module" used in this specification refers to a unit for processing at least one function or operation, and the section or module may be implemented using software, hardware, or a combination of software and hardware.

In addition, lines or members connecting components shown in the drawings merely illustrate functional connections and/or physical or circuit connections. In an actual device, components may be represented as connected by various replaceable or additional functional connections, physical connections, or circuit connections.

In addition, it should be understood that terms containing an ordinal, such as "first" or "second", may be used in the specification to describe various elements, but these elements are not limited by these terms. These terms are only used to distinguish one component from another.

In addition, the sizes or proportions of some components shown in the drawings may be exaggerated. In addition, some components shown in one drawing may not be shown in other drawings.

Throughout the specification, "embodiments" are arbitrary distinctions intended to facilitate the description of the invention in the present disclosure, and are not necessarily mutually exclusive. For example, configurations disclosed in one embodiment may be applied and/or implemented in another embodiment, and may be applied and/or implemented with modifications, without departing from the scope of the present disclosure.

In addition, terms used in the present disclosure are intended to describe the embodiments and are not intended to limit the embodiments. In the present disclosure, singular forms are intended to include plural forms unless explicitly stated otherwise.

Hereinafter, embodiments of the present disclosure will be described in detail with reference to the accompanying drawings so that a person having ordinary skill in the art may easily put the present disclosure into practice. However, embodiments of the present disclosure may be realized in various different forms and are not limited to the embodiments described in the present disclosure.

The present disclosure will be described in detail hereinafter with reference to the accompanying drawings.

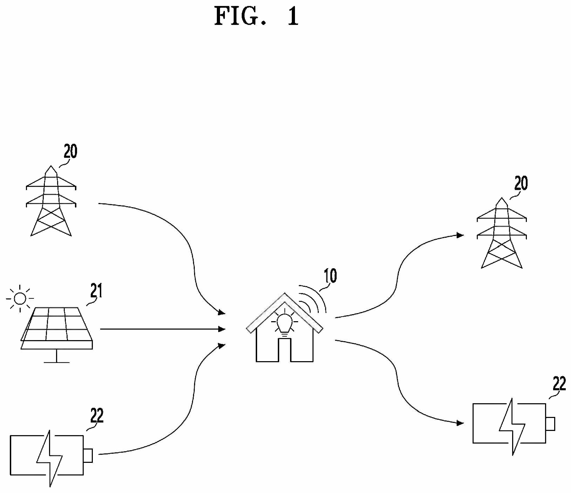

FIG. 1 is a view illustrating electrical energy flow of an electricity consumer according to an embodiment of the present disclosure.

Referring to FIG. 1, an electricity consumer 10 is any place that consumes electrical energy, such as a house, commercial facilities, and a factory, and also refers to a power consumer. The electricity consumer 10 may use electrical energy imported from a power grid 20, a solar generator 21, a battery 22, and the like. That is, the electricity used by the electricity consumer 10 may be imported from any of the power grid 20, the solar generator 21, and the battery 22.

The power grid 20 is an infrastructure system for generating, transmitting, and distributing electrical energy, includes power plants, substations, wire networks, and the like, and delivers electrical energy generated at power plants to electricity consumers 10.

The solar generator 21 is a device that converts solar energy into electrical energy, and may include solar panels, solar cells, and the like. The solar generator 21 may require a storage device, such as a battery 22, because the daily power generation fluctuates depending on the weather or the intensity of sunlight, and power generation may continue while the sun is shining.

The battery 22 stores at least a portion of the electrical energy generated by the solar generator 21 for use as needed. The battery 22 is used to improve the reliability of the power grid 20 and maintain the consistency of the power supply by storing electrical energy during periods of low power demand for later use during periods of high power demand. That is, the electrical energy may be supplied to the electricity consumer 10 by discharging the battery 22.

On the other hand, the operating time of the solar generator 21 is from after sunrise to before sunset, and the power generation efficiency of the solar generator 21 increases during the daytime, mainly from 9 a.m. to 3 p.m. Therefore, during the time when the power generation efficiency of the solar generator 21 is high, in the electrical energy consumption of the electricity consumer 10, the ratio of the use of self-generated energy may increase and the ratio of the use of electrical energy imported from the power grid 20 may decrease.

In addition, electrical energy generated by the electricity consumer 10 may be exported to the power grid 20, the battery 22, and the like.

Specifically, the electricity consumer 10 may generate electrical energy by power generation, for example, for its own use. In this case, a portion of the generated electrical energy may be exported to the power grid 20 or may charge the battery 22.

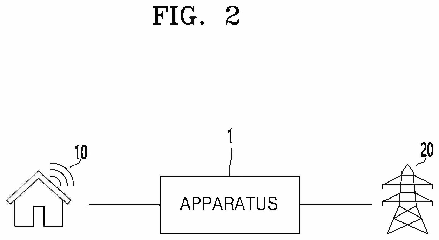

FIG. 2 is an example view of an environment providing an energy consumption score of a consumer according to an embodiment of the present disclosure.

Referring to FIG. 2, an apparatus 1 for providing an energy consumption score (hereinafter, referred to as an "apparatus") according to an embodiment may calculate an energy consumption score of the consumer 10 based on the electrical energy consumption of the consumer 10 according to the time period and the amount of grid electrical energy imported from the power grid 20.

First, the apparatus 1 may obtain amounts of electrical energy consumed by the consumer 10 according to the time period. For example, the amounts of electrical energy consumed by the consumer 10 according to the time period may be amounts of electrical energy consumed at one-hour intervals.

In this case, the amount of electrical energy consumed by the consumer 10 may be imported from the power grid 20, a solar generator (not shown), a battery (not shown), or the like. In an embodiment, the apparatus 1 may obtain the amount of grid electric energy imported from the power grid 20 in the electrical energy consumption of the consumer 10.

In an embodiment, the apparatus 1 may calculate an energy consumption score of the consumer 10 based on the amount of electrical energy consumption and the amount of grid electrical energy. For example, the apparatus 1 may calculate a lower energy consumption score for a higher ratio of the amount of grid electric energy to the amount of electrical energy consumption. That is, for a higher ratio of the amount of electrical energy imported from the power grid and consumed to the amount of electrical energy self-generated and consumed or discharged from a pre-charged battery and consumed in the electrical energy of the consumer 10, the energy consumption score may be calculated to be lower.

In an embodiment, the apparatus 1 may calculate a higher energy consumption score for a higher ratio of the amount of green energy to the amount of grid electric energy. For example, the apparatus 1 may obtain data regarding the type of electrical energy that the consumer 10 imports from a utility that operates the power grid. The type of electrical energy that the consumer 10 imports from the utility may include fossil fuel energy, nuclear energy, green energy (or renewable energy), biomass, and the like. In this case, green energy may refer to electrical energy generated from renewable energy sources such as sunlight, wind, water power, geothermal energy, and the like. For a higher ratio of the amount of green energy to the amount of grid electrical energy imported to the consumer 10, the apparatus 1 may calculate a higher energy consumption score.

In an embodiment, the apparatus 1 may calculate the amount of carbon emission based on the electrical energy consumption of the consumer 10. The amount of carbon emission associated with the electrical energy consumption may vary significantly depending on the type of electrical energy. For example, green energy generation has little or no carbon emission because carbon is not released into the atmosphere. In contrast, fossil energy generation produces a significant amount of carbon emission because burning fossil fuels such as coal, oil, and natural gas releases greenhouse gases such as carbon dioxide into the atmosphere. In the case of nuclear energy, there is almost no carbon emission in the process of generating electricity, but carbon emission is involved in the production of nuclear fuel and waste disposal. Therefore, the apparatus 1 may calculate the amount of carbon emission according to the type of electrical energy consumed by the consumer 10.

In an embodiment, the apparatus 1 may calculate an energy consumption score based on the amount of carbon emission of the consumer 10. For example, the apparatus 1 may calculate a lower energy consumption score for a greater amount of carbon emission of the consumer 10 and a higher energy consumption score for a smaller amount of carbon emission.

In an embodiment, the apparatus 1 may obtain an electrical energy consumption pattern of the consumer 10 extracted from the amount of electrical energy consumption. For example, the electrical energy consumption pattern of the consumer 10 may include a case where the amount of electrical energy consumed by a particular load (e.g., a washing machine) during a particular time of day (e.g., from 11 p.m. to 8 a.m.) is less than a predetermined value or a case where the amount of electrical energy consumed by a particular load during a particular time of day is greater than a predetermined value.

In an embodiment, the apparatus 1 may adjust the amount of electrical energy consumption by controlling the supply of electrical energy to one or more loads of the consumer 10 based on the electrical energy consumption pattern. For example, if the electrical energy consumption pattern of the consumer 10 indicates that the amount of electrical energy consumption by a particular load during a particular time of day is less than a predetermined value, the apparatus 1 may adjust the amount of electrical energy consumption by blocking the supply of electrical energy to the load. Specifically, the apparatus 1 may cut off the standby power of the load.

In an embodiment, the apparatus 1 may calculate an energy consumption score based on the adjusted amount of electrical energy consumption. According to the embodiment described above, it may be seen that as the apparatus 1 controls the supply of electrical energy to one or more loads of the consumer 10, the amount of electrical energy consumption decreases. Accordingly, at this time, a high energy consumption score may be calculated.

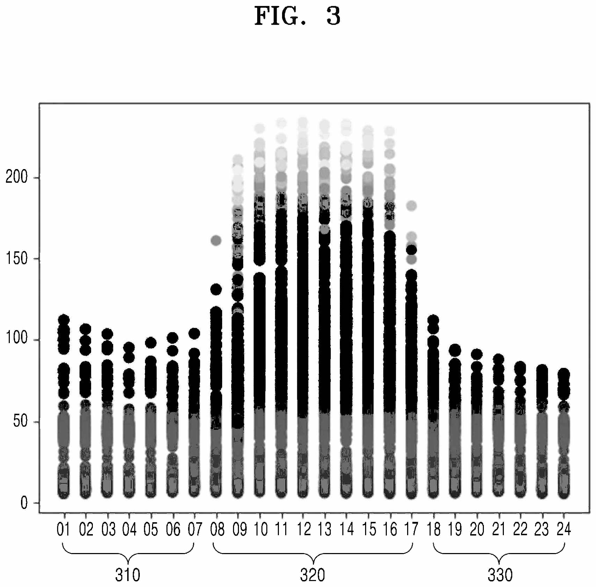

FIG. 3 is a view illustrating amounts of electrical energy consumed according to the time period according to an embodiment of the present disclosure.

Referring to FIG. 3, amounts of electrical energy consumed during a first time period 310 and a second time period 320 may be observed. In FIG. 3, the horizontal axis represents time periods of the day at one-hour intervals, and the vertical axis represents amounts of electrical energy consumed (kWh). The brightly colored areas represent maximum demand (i.e., peak power).

Generally, it may be seen that the amount of electrical energy consumption and the peak demand are increased in the second time period 320 corresponding to daytime hours, and the amount of electrical energy consumption and the peak demand are relatively decreased in the first time period 310 corresponding to non-daytime hours. In this case, greater peak demand may indicate a time period during which a greater amount of electrical energy is imported from the power grid to consumers.

However, the graph of the amounts of electrical energy consumed shown in FIG. 3 is only an embodiment, and may change depending on various factors such as the consumer and the season.

In an embodiment, the apparatus may add points to the energy consumption score for electrical energy consumed by the consumer in the first time period 310 and subtract points from the energy consumption score for electrical energy consumed by the consumer in the second time period 320. For example, the first time period 310 may be a time period during which a small amount of electrical energy is imported from the power grid, and the second time period 320 may be a time period during which a large amount of electrical energy is imported from the power grid.

In addition, the first time period 310 and the second time period 320 may be predetermined. Specifically, the first time period 310 and the second time period 320 may be predetermined by taking into account the time periods when small and large amounts of electrical energy are imported from the power grid and/or small and large amounts of electrical energy are consumed by the consumers. In addition, the first time period 310 and the second time period 320 may be set separately to regulate the amount of grid electrical energy imported from the utility or power grid to the consumer.

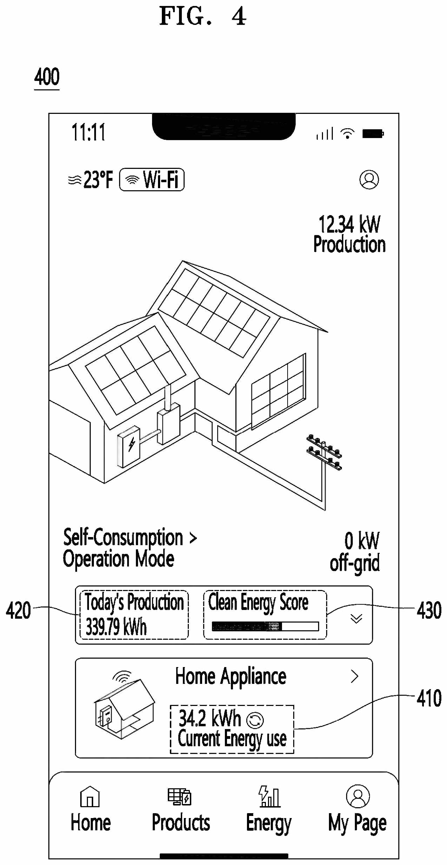

FIG. 4 is an example view of an interface displaying an energy consumption score according to an embodiment of the present disclosure.

In an embodiment, the apparatus may generate an interface 400 that displays an energy consumption score 430. For example, the interface 400 may quantitatively display an amount of consumer's electrical energy consumption 410 and an amount of consumer-generated energy 420.

The amount of consumer's electrical energy consumption 410 displayed on the interface 400 may mean the amount consumed in real time on the corresponding date. The amount of consumer-generated energy 420 displayed on the interface 400 may mean the amount of electrical energy generated by the consumer on the corresponding date.

In an embodiment, the interface 400 may display the energy consumption score 430 in the form of a bar. By displaying the energy consumption score 430 in the form of a bar, the consumer or the user of the interface 400 may intuitively recognize the status of electrical energy consumption. Accordingly, there may be a motivation to improve electrical energy consumption and an incentive to use renewable energy.

In an embodiment, the apparatus may generate different interfaces 400 for the first time period and the second time period. For example, an interface with a dark background representing night may be generated during a time period during which a small amount of electrical energy is imported from the power grid, and an interface with a light background representing day may be generated during a time period during which a large amount of electrical energy is imported from the power grid. Accordingly, the consumer or the user of the interface 400 may intuitively recognize whether energy consumption score will be added or subtracted based on the current consumption of electrical energy, thereby using electricity efficiently.

In another embodiment, the apparatus may generate an interface, the color of which is change in response to user input. For example, in response to receiving the user input selecting a light theme, the apparatus may generate a light theme interface including a background having a light and transparent color (e.g., white, light gray, or other light color) and text/icons having a dark color (e.g., black, gray, or other dark color). In another example, in response to receiving the user input selecting a dark theme, the apparatus may generate a dark theme interface including a background having a dark color and text/icons having a light color. That is, according to this embodiment, the apparatus may change the color of the interface in response to the user input selecting a theme for the interface, regardless of the time period. However, the embodiment in which the apparatus generates an interface is not limited thereto, and the color and type of the interface is not limited to the light theme or the dark theme.

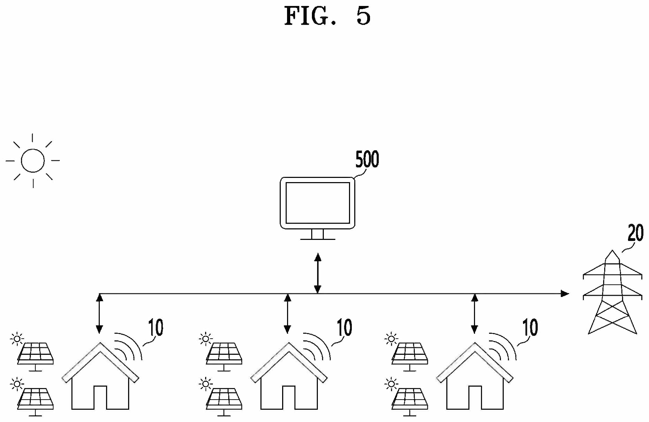

FIG. 5 is an example view of a virtual power plant (VPP) implementation according to an embodiment of the present disclosure.

The virtual power plant includes a network of distributed solar generation and battery systems coordinated by a central VPP operator 500. In an embodiment, the central VPP operator 500 may transmit a VPP discharge signal to discharge a portion of the energy stored in the batteries to the power grid 20 during peak power time periods when wholesale electric energy prices are high. Similarly, the central VPP operator 500 may transmit a VPP charge signal to charge the batteries from the power grid 20 when the stability of the power grid 20 is threatened due to low electricity demand.

In an embodiment, the consumer 10 may be included in a virtual power plant. That is, the consumer 10 may be a portion of a virtual power plant and export electrical energy stored in the battery to the power grid 20 or import electrical energy from the power grid 20 in response to VPP discharge signal or the VPP charge signal received from the central VPP operator 500.

In an embodiment, the first time period described above is a VPP event period based on the VPP charging signal, and the second time period may be a time period other than the VPP event period. The VPP event period may refer to a time period during which the VPP operator 500 transmits a VPP charge signal to the consumer 10 when the power grid 20 requires stabilization, such as in a state where the power grid 20 is overloaded. The duration of the VPP event may be determined based on duration information included in the VPP charge signal, or may be determined based on an end-of-event signal from the VPP operator 500.

That is, the apparatus may add points to the energy consumption score for electrical energy consumed by the consumer 10 in the first time period, which is a VPP event period, by charging the battery with electrical energy imported from the power grid 20. Similarly, the apparatus may subtract points from the energy consumption score for electrical energy that the consumer 10 imports from the power grid 20 in the second time period other than the VPP event period.

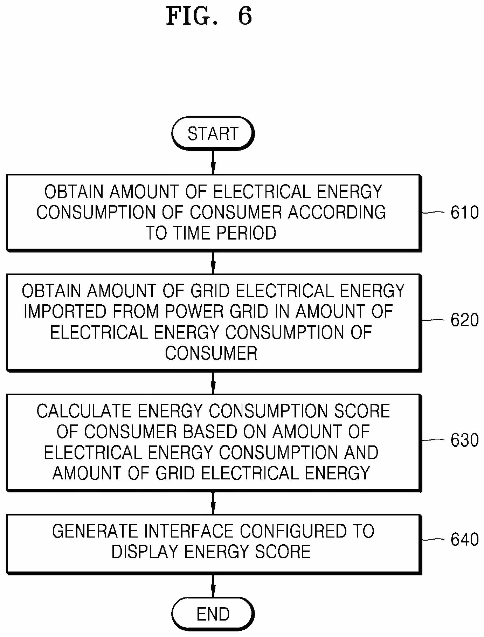

FIG. 6 is a flowchart of a method of providing an energy consumption score of a consumer according to an embodiment of the present disclosure.

Referring to FIG. 6, in step 610, the apparatus may obtain an amount of electrical energy consumption of the consumer according to the time period.

In an embodiment, the consumer may be included in a virtual power plant.

In step 620, the apparatus may obtain an amount of grid electric energy imported from the power grid in the amount of electrical energy consumption of the consumer.

In step 630, the apparatus may calculate an energy consumption score of the consumer based on the amount of electrical energy consumption and the amount of grid electrical energy.

In an embodiment, the apparatus may award points to the energy consumption score for electrical energy consumed by the consumer in a first time period and subtract points from the energy consumption score for electrical energy consumed by the consumer in a second time period.

In an embodiment, the first time period is a time period during which a small amount of electrical energy is imported from the power grid, and the second time period is a time period during which a large amount of electrical energy is imported from the power grid, wherein the first time period and the second time period may be predetermined time periods.

In an embodiment, the first time period may be a VPP event period according to the VPP charge signal, and the second time period may be a time period other than the VPP event period.

In an embodiment, the apparatus may calculate a higher energy consumption score for a higher ratio of the amount of green energy to the amount of grid electric energy.

In an embodiment, the apparatus may calculate an amount of carbon emission based on the electrical energy consumption of the consumer.

In an embodiment, the apparatus may calculate the energy consumption score based on the amount of carbon emission of the consumer.

In an embodiment, the apparatus may obtain an electrical energy consumption pattern of the consumer extracted from the amount of electrical energy consumption.

In an embodiment, the apparatus may adjust the amount of electrical energy consumption by controlling the import of electrical energy to one or more loads of the consumer based on the electrical energy consumption pattern.

In an embodiment, the apparatus may calculate the energy consumption score based on the adjusted amount of electrical energy consumption.

In step 640, the apparatus may generate an interface that displays energy consumption scores.

In an embodiment, the interface may quantitatively display the amount of electrical energy consumption of the consumer and the amount of energy generated by the consumer.

In an embodiment, the interface may display the energy consumption score in the form of a bar.

In an embodiment, the apparatus may generate different interfaces for the first time period and the second time period.

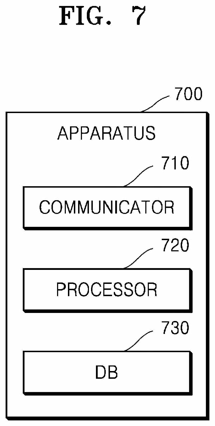

FIG. 7 is a block diagram of an apparatus for providing an energy consumption score of a consumer according to an embodiment of the present disclosure.

Referring to FIG. 7, an apparatus 700 may include a communicator 710, a processor 720, and a DB 730. The apparatus 700 of FIG. 7 only shows the components according to the embodiment. Accordingly, it will be understood by a person having ordinary skill in the art that general purpose components other than those shown in FIG. 7 may be further included.

The communicator 710 may include one or more components that enable wired or wireless communication with an external server or an external apparatus. For example, the communicator 710 may include at least one of a local area communicator (not shown), a mobile communicator (not shown), and a broadcast receiver (not shown).

The DB 730 is hardware that stores various data processed within the apparatus 700, and may store programs for processing and controlling the processor 720.

The DB 730 may include random access memory (RAM), such as dynamic random access memory (DRAM) and static random access memory (SRAM), read-only memory (ROM), electronically erasable programmable read-only memory (EEPROM), a CD-ROM, Blu-ray or other optical disk storage, a hard disk drive (HDD), a solid state drive (SSD), or flash memory.

The processor 720 controls the overall operation of the apparatus 700. For example, the processor 720 may control the overall operation of inputs (not shown), a display (not shown), the communicator 710, the DB 730, and the like by executing the programs stored in the DB 730. The processor 720 may control the operation of the apparatus 700 by executing the programs stored in the DB 730.

The processor 720 may control at least some of the operations of the apparatus for providing an energy consumption score described above in FIGS. 1 through 6.

The processor 720 may be implemented using at least one of application specific integrated circuits (ASICs), digital signal processors (DSPs), digital signal processing devices (DSPDs), programmable logic devices (PLDs), field programmable gate arrays (FPGAs), controllers, microcontrollers, microprocessors, and other electrical units for performing functions.

In an embodiment, the apparatus 700 may be a server. The server may be implemented as a computing device or a plurality of computing devices that communicate over a network to provide commands, code, files, content, services, and the like. The server may receive data necessary to provide the energy consumption score of the consumer, and may provide the consumer energy consumption score based on the data received.

Embodiments according to the present disclosure may be implemented in the form of a computer program that may be executed by various components on a computer, and such a computer program may be recorded on a computer-readable medium. The medium may include magnetic media such as hard disks, floppy disks, and magnetic tape, optical recording media such as compact disc read-only memories (CD-ROMs) and digital versatile discs (DVDs), magneto-optical media such as floptical disks, and hardware devices specifically configured to store and execute program instructions, such as ROM, RAM, flash memory, and the like.

In addition, the computer program may be specifically designed and constructed for the present disclosure, or may be known and available to a person having ordinary skill in the art of computer software. Examples of computer programs may include machine language code, such as that produced by a compiler, as well as high-level language code that may be executed by a computer using an interpreter or the like.

According to an embodiment, methods according to various embodiments of the present disclosure may be provided included in a computer program product. The computer program product is a commodity, and may be traded between a seller and a buyer. The computer program product may be distributed in the form of a devicereadable storage medium (e.g., a CD-ROM), or may be distributed online (e.g., downloaded or uploaded) through an application store (e.g., Play Store^{™}) or directly between two user devices. In the case of online distribution, at least a portion of the computer program product may be stored or at least temporarily generated on a devicereadable storage medium, such as a memory, of a manufacturer's server, an application store's server, or a relay server.

Unless explicitly stated herein or otherwise, the steps of the method according to the present disclosure may be performed in any suitable order. The present disclosure is not necessarily limited to the order in which the steps are described above. The use of any examples or illustrative terms herein is only for the purpose of describing the present disclosure in detail and the scope of the present disclosure is not limited to the examples or illustrative terms unless defined by the claims. In addition, a person having ordinary skill in the art will appreciate that various modifications, combinations, and alterations are possible depending on the design conditions and factors within the scope of the appended claims or equivalents thereof.

Therefore, it should be understood that the spirit of the present disclosure is not limited to the foregoing embodiments, and the scope of the appended claims, as well as all scopes equivalent to or equivalently modified from the scope of the claims, are included within the scope of the spirit of the present disclosure.

## Claims

1. A method of providing an energy consumption score of a consumer, the method comprising:
obtaining an amount of electrical energy consumption of a consumer according to a time period;
obtaining an amount of grid electrical energy imported from a power grid in the amount of electrical energy consumption of the consumer;
calculating an energy consumption score of the consumer based on the amount of electrical energy consumption and the amount of grid electrical energy; and
generating an interface configured to display the energy consumption score.

2. The method of claim 1,
wherein the calculating the energy consumption score comprises awarding points to the energy consumption score for electrical energy consumed by the consumer during a first time period and subtracting points from the energy consumption score for electrical energy consumed by the consumer during a second time period.

3. The method of claim 2,
wherein the first time period is a time period during which a small amount of electrical energy is imported from the power grid,
the second time period is a time period during which a large amount of electrical energy is imported from the power grid, and
the first time period and the second time period are predetermined.

4. The method of claim 1,
wherein the calculating the energy consumption score comprises calculating the energy consumption score to be higher for a higher ratio of the amount of green energy to the amount of grid electric energy.

5. The method of claim 4,
wherein the calculating the energy consumption score comprises:
calculating an amount of carbon emission based on the electrical energy consumption of the consumer; and
calculating the energy consumption score based on the amount of carbon emission of the consumer.

6. The method of claim 1,
wherein the calculating the energy consumption score comprises:
obtaining an electrical energy consumption pattern of the consumer extracted from the amount of electrical energy consumption;
adjusting the amount of electrical energy consumption by controlling the import of electrical energy to one or more loads of the consumer based on the electrical energy consumption pattern; and
calculating the energy consumption score based on the adjusted amount of electrical energy consumption.

7. The method of claim 2,
wherein the consumer is included in a virtual power plant (VPP),
the first time period is a VPP event period based on a VPP charging signal, and
the second time period is a period other than the VPP event period.

8. The method of claim 1,
wherein the interface
quantitatively displays the amount of electrical energy consumption of the consumer and an amount of energy generated by the consumer, and
displays the energy consumption score in a form of a bar.

9. A computer-readable recording medium having recorded thereon a
program to cause the method of claim 1 to be executed.

10. An apparatus for providing an energy consumption score of a consumer,
the apparatus comprising:
a memory having at least one program stored therein; and
a processor configured to perform calculation by executing the at least one program,
wherein the processor is further configured to:
obtain an amount of electrical energy consumption of a consumer according to a time period;
obtain an amount of grid electrical energy imported from a power grid in the amount of electrical energy consumption of the consumer; calculate an energy consumption score of the consumer based on the amount of electrical energy consumption and the amount of grid electrical energy; and
generate an interface configured to display the energy consumption score.

11. The apparatus of claim 10,
wherein the processor is further configured to:
award points to the energy consumption score for electrical energy consumed by the consumer during a first time period and subtract points from the energy consumption score for electrical energy consumed by the consumer during a second time period.

12. The apparatus of claim 11,
wherein the first time period is a time period during which a small amount of electrical energy is imported from the power grid,
the second time period is a time period during which a large amount of electrical energy is imported from the power grid, and
the first time period and the second time period are predetermined.

13. The apparatus of claim 10,
wherein the processor is further configured to calculate the energy consumption score to be higher for a higher ratio of the amount of green energy to the amount of grid electric energy.

14. The apparatus of claim 13,
wherein the processor is further configured to:
calculate an amount of carbon emission based on the electrical energy consumption of the consumer; and
calculate the energy consumption score based on the amount of carbon emission of the consumer.

15. The apparatus of claim 10,
wherein the processor is further configured to:
obtain an electrical energy consumption pattern of the consumer extracted from the amount of electrical energy consumption;
adjust the amount of electrical energy consumption by controlling the import of electrical energy to one or more loads of the consumer based on the electrical energy consumption pattern; and
calculate the energy consumption score based on the adjusted amount of electrical energy consumption.

16. The apparatus of claim 11,
wherein the consumer is included in a virtual power plant (VPP), the first time period is a VPP event period based on a VPP charging signal, and
the second time period is a period other than the VPP event period.

17. The apparatus of claim 10,
wherein the interface
quantitatively displays the amount of electrical energy consumption of the consumer and an amount of energy generated by the consumer, and
displays the energy consumption score in a form of a bar.
